# EUROPEAN PATENT APPLICATION

(11) **EP 4 006 766 A1**
(43) Date of publication of application: **01.06.2022**
(21) Application number: 21209697.8
(22) Date of filing: 22.11.2021
(51) Int. Cl.: G06F 30/23, G06F 30/25, G06F 30/28

(54) **CORRECTION MASK FOR FINITE ELEMENT METHODS**

(30) Priority: 20.11.2020 US 202063116720 P; 20.11.2021 US 202117531747
(71) Applicant: Silver Fir Software, Inc., Cle Elum, WA 98922 (US)
(72) Inventor: SOSNOVSKY, Eugeny, Gig Harbor, 98335 (US)
(74) Representative: Gill, David Alan

(57) **Abstract**

A finite element method (100) for solving a steady state fixed source multigroup particle transport problem using a discretized geometric mesh includes, for each group, initializing all values of a Boolean array mask to false, with each value corresponding to an element of the discretized geometric mesh. The method further includes performing a first sweep through the discretized geometric mesh to compute a solution function at each element of the discretized mesh (102). While performing the sweep, and for each element having a negative solution value computed at any part of the element during the sweep, or for each element corresponding to a true value of the Boolean array mask, computing an adaptive solution function for each element having a negative solution value of the solution function at any part of the element or for each element corresponding to a true value of the Boolean array mask (104).

## Description

### CROSS REFERENCE TO RELATED APPLICATIONS

This application claims priority to U.S. Provisional Patent Application No. 63/116,720 filed on November 20, 2020, the disclosure of which is incorporated herein, in its entirety, by this reference.

### BACKGROUND OF THE INVENTION

Computer modeling, simulation, and analysis of real-world environments are typically very computationally expensive applications. These applications rely on various mathematical models to predict complex geometries and dynamic motions. Discontinuous Finite Element Method (DFEM), (also known as Discontinuous Finite Element Analysis or DFEA), is frequently used in the implementation of scientific and engineering software that solves partial differential and integro-differential equations (P(I)DEs) that model numerous physics, including particle transport, fluid dynamics, heat transfer, and radiofrequency structures. Further detail of traditional uses of DFEM in solving P(I)Des are described in Discontinuous Finite Elements in Fluid Dynamics and Heat Transfer, by B. Q. Li (Springer, London, UK, 2006; DOI 10.1007/1-84628-205-5; URL: https://doi.org/10.1007/1-84628-205-5), which reference is incorporated herein by reference for all that it contains.

### BRIEF SUMMARY OF THE INVENTION

In at least one example of the present disclosure, a finite element method for solving a steady state fixed source multigroup particle transport problem using a discretized geometric mesh can include, for each group, initializing all values of a Boolean array mask to false, with each value corresponding to an element of the discretized geometric mesh. In one example, the method further includes performing a first sweep through the discretized geometric mesh to compute a solution function at each element of the discretized mesh. While performing the sweep, and for each element having a negative solution value computed at any part of the element during the sweep, or for each element corresponding to a true value of the Boolean array mask, computing an adaptive solution function for each element having a negative solution value of the solution function at any part of the element or for each element corresponding to a true value of the Boolean array mask.

In at least one example, the method can include updating a scattering source term according to the adaptive solutions, and performing a second sweep through the discretized geometric mesh. Subsequent sweeps can include re-computing the combined external-plus-scattering source terms, sweeping through the geometric mesh again, and computing an adaptive solution function for each element having a negative solution value in any part of itself in any of the sweeps. Sweeps are repeated until the solution converges.

In at least one example of the present disclosure, a finite element method for solving a steady state fixed source multigroup particle transport problem can include discretizing a geometry into a contiguous mesh of elements, discretizing the angular space into discrete ordinates, and for each group, initializing a Boolean array with one value per (mesh element, discrete ordinate pair) to false values, and performing a first sweep through the geometry along each discrete ordinate to compute a solution function at each element of the discretized mesh along each ordinate. Performing this first sweep can include setting each element of the Boolean array mask that corresponds to a partly or fully negative solution to true, and adaptively re-computing a nonnegative solution function for the (mesh element, discrete ordinate) pair. The adaptivity can be implemented as the averaging of the previously computed solution function over the element. The second and subsequent sweeps can be performed with updated combined external-plus-scattering source terms and similarly adaptively computing a nonnegative solution function for any (mesh element, discrete ordinate) pair corresponding to a true Boolean array mask value, and again setting the corresponding Boolean array mask element to true for every corresponding new partially or fully negative solution. Sweeps are repeated until the solution converges.

In at least one example of the present disclosure, an electronic device can include a processor, a memory unit in electronic communication with the processor and comprising non-transitory computer-readable electronic instructions. When performed by the processor, the instructions cause the processor to discretize a geometry into a contiguous mesh of elements, with the solution in each element discretized into non-polynomial discontinuous basis functions including trigonometric functions or Fourier-Bessel functions, perform a first sweep through the geometry and update the source term, and perform similar second and subsequent sweeps through the geometry. The first sweep can include initializing a mesh-sized Boolean array mask to all false values and during the performance of the first sweep, if the solution in an element satisfies a predetermined condition, setting a Boolean array mask value corresponding to the element to true and adaptively treating the element by computing an adaptive solution value (adaptivity can include using a different basis function, or a single element-wide value to represent the solution in the element), and setting the solution of the element to the adaptive solution. The second and subsequent sweeps can include recomputing the source term to use the new solution values, similarly setting to true the Boolean array mask values that correspond to elements with solutions that satisfy a predetermined condition, and adaptively treating all elements for which a corresponding Boolean array mask value is true. Sweeps are repeated until the solution converges.

### BRIEF DESCRIPTION OF THE DRAWINGS

FIG. 1 illustrates a flowchart of an example of a finite element method for solving a partial differential equation, according to the present disclosure;
FIG. 2 illustrates a flowchart of an example of an iterative finite element method for solving a steady state fixed source multigroup particle transport problem with the angular space discretized into discrete ordinates, according to the present disclosure;
FIG. 3 illustrates a flowchart of an example of an iterative finite element method for solving a steady state multigroup particle transport problem, according to the present disclosure;
FIG. 4 illustrates a flowchart of an example of a finite element method for solving a partial differential equation, according to the present disclosure;
FIG. 5 illustrates a photon flux solution field from a point source shielded by a concrete shield solved with a conventional Linear Discontinuous Finite Element Method (LDFEM);
FIG. 6 illustrates a photon flux solution field from a point source shielded by a concrete shield solved with a Linear Discontinuous Adaptive to Step (LDAS) finite element method, according to the present disclosure;
FIG. 7 illustrates a *photon* flux solution field from a volume source in a finned cask in a room with concrete walls solved with the conventional LDFEM spatial discretization;
FIG. 8 illustrates a photon flux solution field from a volume source in a finned cask in a room with concrete walls solved with an LDAS finite element method, according to the present disclosure;
FIG. 9 illustrates a low scattering problem solved with a convention LDFEM method;
FIG. 10 illustrates a low scattering problem solved with an LDAS finite element method, according to the present disclosure;
FIG. 11 shows a plot comparing the performance of LDAS versus LDFEM and step spatial discretization for a ⁶⁰Co photon source with a 200 cm thick concrete shield and a concrete density of 2.07 g/cc;
FIG. 12 shows a plot comparing the performance of LDAS versus LDFEM and step spatial discretization for a ⁶⁰Co photon source with a 200 cm thick concrete shield and a concrete density of 2.30 g/cc; and
FIG. 13 shows a plot comparing the performance of LDAS versus LDFEM and step spatial discretization for a ⁶⁰Co photon source with a 200 cm thick concrete shield and a concrete density of 2.76 g/cc.

### DETAILED DESCRIPTION OF THE INVENTION

In general, Linear DFEM (LDFEM), which is essentially DFEM with linear basis functions, is more accurate than, for example, step spatial discretization, because it can better resolve the solution in individual elements, while step spatial discretization averages it. However, when a first-order spatial discretization operator is present in the P(I)DE, LDFEM can converge to a negative solution in some of the finite elements, even in problems where such negativities are nonphysical. Consequently, there is a need for a method that maintains the accuracy of LDFEM while eliminating the convergence to a negative solution in some of the finite elements when a first-order spatial discretization operator is present in the P(I)DE.

While some LDFEM negativity correction schemes in some of the above physics do exists, such as the negative particle flux fixup scheme disclosed in Negative Flux Fixups in Discontinuous Finite Element SN Transport by S. Hamilton, M. Benzi and J. Warsa (M&C. Saratoga Springs, NY, USA, May 3-7, 2009), which reference is incorporated herein by reference for all that it contains, additional adaptable methods are desired.

Examples of the finite element methods, systems, and devices described herein incorporate an LDFEM negativity correction scheme including a correction mask. This process maintains the accuracy of LDFEM in sections of the geometry where the negatives do not occur, while eliminating the convergence to a negative solution in some of the finite elements when a first-order spatial discretization operator is present in the P(I)DE.

One example of a method described herein can be referred to as a Linear Discontinuous Adaptive to Step (LDAS) method. Such a method can be applied to a solving a steady state fixed source multigroup particle transport problem. In one example of the method a geometry can be discretized into a contiguous tetrahedral mesh, with linear spatial basis functions per element (*i.e.,* LDFEM on tetrahedral elements).

In one example, the angular dependence can be discretized in discrete ordinates (S*_{N}*) for streaming, and may be discretized in spherical harmonics (P*_{N}*) or also in discrete ordinates for scattering and for storing the solution flux itself. In at least one example, the energy can be discretized into energy groups (multigroup) and the groups can be solved for sequentially. Note, therefore, that methods described herein relate to the solution over a single group.

It is also noted that there is no time dependence, as the problems described in the present disclosure are steady state problems. In addition, many solvers that use similar discretizations as discussed above solve each group in the problem by sweeping through the geometry along each discrete ordinate (*i.e.*, "each angle"), updating the scattering term, and sweeping again with the updated combined (external + scattering) source. This can be done iteratively until the solution converges.

In contrast, exemplary methods described in the present disclosure consist of modifying the sweeping procedure. For instance, in at least one example, a *T* × *D* Boolean array *M* (*T:* number of tetrahedral elements in the mesh; *D:* number of discrete ordinates in the angular discretization), referred to herein as a "mask," is first initialized to all false values.

In at least one example, during the first sweep along a given discrete ordinate d, if a sweep through any element *t* yields any negative solution values at any point of the element (LDFEM over tetrahedral elements implies the use of four unknowns per element, one per vertex), an adaptive procedure can be implemented. In at least one example of the adaptive procedure, a corresponding *M_{t,d}* value can be set to true, thus indicating that the element will then be treated adaptively.

In at least one example, the four solution values of the element's vertices can then be averaged, and all four vertices to this average. As long as the combined source is positive, this average is mathematically guaranteed to be positive. This specific form of adaptive treatment is referred to herein as "adaptivity to step." However, other adaptive treatments are also contemplated herein as discussed below in more detail. The sweep can then proceed to the next element in the sweep schedule.

In at least one example, after the first sweep, the combined external + scattering (from the previous sweep's solution) source term is recomputed and the geometry can be swept through again in a second sweep. In the second sweep, when sweeping through any element *t* along the discrete ordinate *d,* and *M_{t,d}* is true, the element's solution can be treated adaptively, even if no component of it is positive in this sweep.

These sweeping iterations (referred to as "inner iterations" in radiation and particle transport), including the first and second sweeps discussed above, can continue until a preliminarily specified norm of the difference between the solutions of subsequent iterations is under some specific value, by which point the solution can be considered converged.

In general, the present exemplary mask-based approach can be described as: in any iteratively-solved DFEM problem, during an iteration, replace a negativity-creating spatial discretization with another discretization that does not create this negativity, and use this replacement in all subsequent iterations.

According to this embodiment, the present exemplary approach guarantees the nonnegativity of the solution, as long as the combined source term is nonnegative, while preserving the higher fidelity of the solution in the areas of the geometry that do not require the above mask-based adaptivity.

While the algorithm described above can apply to multigroup particle transport equations solved with LDFEM over a tetrahedral mesh, similar mask-based corrections can be applied to other iteratively-solved DFEM problems, including both in other physics, and in multigroup particle transport, but adaptive not to step but in other ways.

For example, modifications that can be made to methods described herein can include, but are in no way limited to, the use of the conservative flux fixup by Hamilton, *et al.* (noted above), instead of the adaptivity to step (as in the description above), in sweep-based multigroup discrete ordinates radiation transport solvers. This is similar to what Hamilton *et al.* reported in 1D and 2D problems, but is in 3D, and with a mask-based correction, instead of applying them uniformly.

Modifications that can be made to methods described herein can also include the use of a similar correction in linear and higher-order (e.g., quadratic instead of linear) DFEM P(I)DE solvers, such as in Computational Fluid Dynamics (CFD). More generally, the present exemplary systems and methods can be used for any iterative DFEM solver that can result in negative solutions.

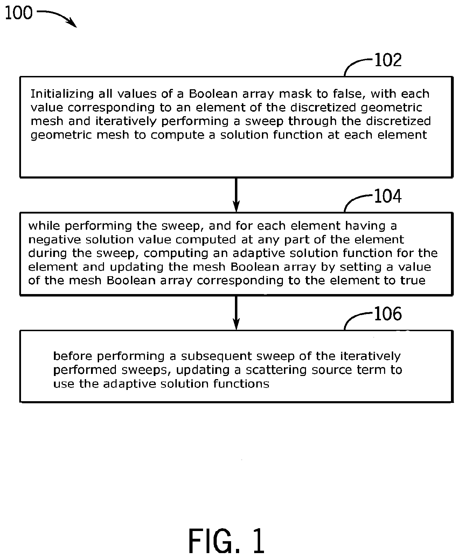

To further illustrate an example of the methods described herein, FIG. 1 illustrates a flowchart of an example of a finite element method 100, according to the present disclosure. In one example, the method 100 can be used to solve a partial differential equation or a system of partial differential equations, using a contiguous geometric mesh generated by discretizing the problem geometry into finite mesh elements. In at least one example, the method 100 can be used for solving a steady state fixed source multigroup particle transport problem using a discretized geometric mesh. One example of the method 100 can include discretizing the solution field in each mesh element into spatial basis functions.

As shown at 102 of the method 100, the method 100 can include initializing all values of a Boolean array mask to false, with each value corresponding to an element of the discretized geometric mesh and iteratively performing a sweep through the discretized geometric mesh to compute a solution function at each element. In one example, after initializing the Boolean array mask, the method 100 can include updating the solution-dependent part of a source term can be based on a previously known, guessed, or randomly obtained approximate solution.

In at least one example, at 104, the method 100 can include, while performing the sweep, and for each element having a negative solution value computed at any part of the element during the sweep, computing an adaptive solution function for the element and updating the mesh Boolean array by setting a value of the mesh Boolean array corresponding to the element to true. In at least one example, at 106 of the method 100, before performing a subsequent sweep of the iteratively performed sweeps, the method 100 can include updating a scattering source term to use the adaptive solution functions.

In at least one example, of the finite element method 100, the sweep is performed iteratively until converging onto a solution, each subsequent sweep of the iteratively performed sweeps uses the updated scattering source term and the updated mesh Boolean array. In at least one example, each subsequent sweep uses the updated solution-dependent part of the source term. In at least one example, converging on the solution includes a norm of the absolute or relative difference between the solution values computed at any part of the element during a previous sweep and a current sweep previous to the previous sweep being less than a predetermined value.

At least one example of the method 100 can include discretizing a solution field in each element into spatial basis functions. The spatial basis functions can include discontinuous polynomial functions and computing the adaptive solution function comprises a re-discretization and re-computation of the solution using a polynomial function of a higher or lower order.

In one example of the method 100, computing the adaptive solution function comprises averaging the solution function across the element. In one example, each element is a tetrahedral mesh element. In one or more examples, discontinuous linear spatial basis functions are used to represent the solution in each element of the discretized geometric mesh. In at least one example, the discretized geometric mesh comprises pentahedral or hexahedral elements.

Any of the steps, features, elements, or methods shown and described with reference to the method 100 of FIG. 1 can be included alone or in any combination with any of the other examples of methods shown and described with reference to other figures. Likewise, any of the steps, features, elements, or methods shown and described with reference to other figures can be included alone or in any combination with the example of the method 100 shown in FIG. 1.

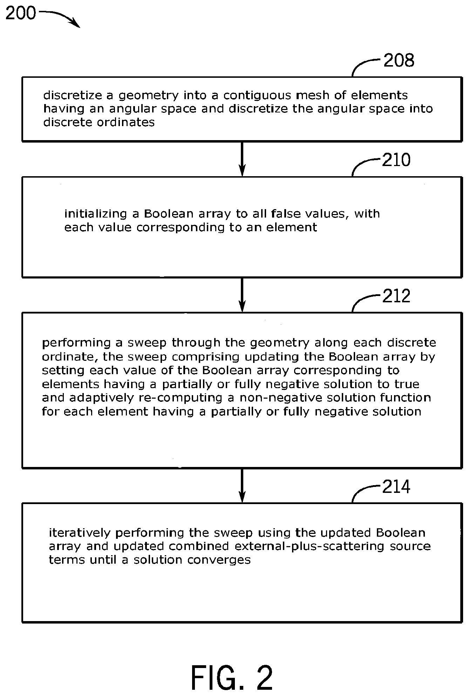

FIG. 2 illustrates a flowchart of another example of a finite element method 200, according to the present disclosure. At least one example of the method 200 can be used to solve a steady state fixed source multigroup particle transport problem. At least one example of the method 200 includes, at 208, discretizing a problem geometry into a contiguous mesh of element-discrete ordinate pairs. In at least one example, before discretizing the problem geometry, the method 200 can include discretizing the solution field in each element into spatial basis functions and discretizing the angular space into discrete ordinates. In at least one example, the method 200 can include, at 210, for each group of the mutligroup, initializing a Boolean array to all false values, with each value corresponding to an element-discrete ordinate pair.

At 212, the method 200 can include performing a sweep through the geometry along each discrete ordinate, the sweep comprising updating the Boolean array by setting each value of the Boolean array corresponding to elements having a partially or fully negative solution to true and adaptively re-computing a non-negative solution function for each element having a partially or fully negative solution. At least one example of the method 200 can include, at 214, iteratively performing the sweep using the updated Boolean array and updated combined external-plus-scattering source terms until a solution converges.

In at least one example, before 212, the method 200 can include updating the combined source term to include the inscattering from other groups, the external source term, and the in-group scattering term computed based on the previous iteration (for the second and subsequent iterations), or on a previously known, guessed or randomly obtained solution (for the first iteration) in the energy group being solved for.

In at least one example of the method 200, adaptively computing a nonnegative solution function comprises averaging the solution function computed in a previous iteration of the iterative sweeps over the element-discrete ordinate pair. In at least one example, second or higher-order discontinuous polynomial basis functions are used to represent the solution in each element-discrete ordinate pair of the contiguous mesh. In at least one example, exponential discontinuous basis functions are used to represent the solution in each element-discrete ordinate pair of the contiguous mesh. In at least one example, the contiguous mesh of elements comprises an unstructured mesh including elements having curved faces.

Any of the steps, features, elements, or methods shown and described with reference to the method 200 of FIG. 2 can be included alone or in any combination with any of the other examples of methods shown and described with reference to other figures. Likewise, any of the steps, features, elements, or methods shown and described with reference to other figures can be included alone or in any combination with the example of the method 200 shown in FIG. 2.

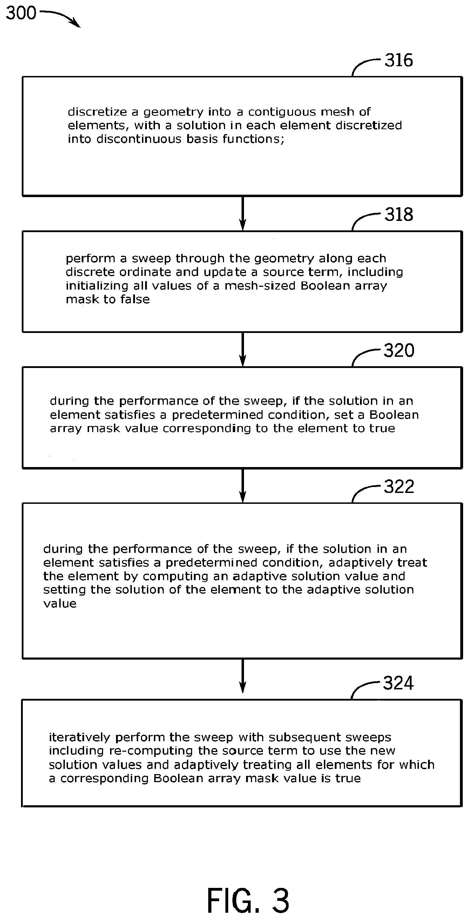

FIG. 3 illustrates a flowchart of another example of a finite element method 300 according to the present disclosure. In at least one example, the method 300 can be used to solve a steady state fixed source multigroup particle transport problem. In at least one example, the method 300 of FIG. 3 can be carried out by an electronic device having a processor and a memory unit electronic communication with the processor. The memory unit can also comprise non-transitory computer-readable electronic instructions that, when performed by the processor, cause the processor to carry out the method 300.

In at least one example, at 316, the method 300 can include discretizing a problem geometry into a contiguous mesh of elements and discrete ordinates, with a solution in each element discretized into spatial basis functions. In at least one example, the method 300 can discretize the angular space into discrete ordinates or in another manner such as spherical harmonics, for storage. In at least one example, at 318, the method 300 can include performing a sweep through the geometry along each discrete ordinate and update a source term.

In at least one example of the method 300, performing the sweep can include initializing all values of a mesh-sized Boolean array mask to false. In at least one example, at 320, the method 300, during the performance of the sweep, if the solution in an element satisfies a predetermined condition, can set a Boolean array mask value corresponding to the element to true and adaptively treat the element by computing an adaptive solution value and setting the solution of the element to the adaptive solution value. In at least one example, at 324, the method 300 can include iteratively performing the sweep with subsequent sweeps including re-computing the source term to use the new solution values and adaptively treating all elements for which a corresponding Boolean array mask value is true.

In at least one example of the method 300 of FIG. 3, the predetermined condition can include of an element can include a negative solution value in any part of the element or a true value of the Boolean array mask corresponding to the element. In at least one example, the adaptive treatment is only applied to a group of elements along a discrete ordinate if the solution in a preset fraction of the elements in the group fails to meet the predetermined condition. In at least one example, the group of elements can include a group of at least two adjacent elements or a predetermined group of elements.

In at least one example, the predetermined condition as applied to the solution of the mesh element along one of the discrete ordinates of the method 300 can include a negative average solution value of an in-element solution value. In at least one example, the predetermined condition as applied to the solution of the mesh element along one of the discrete ordinates of the method 300 can include a negative solution value of more than a pre-specified fraction of a volume of the element. In at least one example, the predetermined condition as applied to the solution of the mesh element along one of the discrete ordinates of the method 300 can include a gradient of an in-element solution of the element being steeper than a pre-specified maximum.

In at least one example of the method 300 of FIG. 3, the contiguous mesh can include tetrahedral elements. In at least one example, the mesh can include a Cartesian axis-aligned orthogonal grid. In at least one example, the mesh can include a Cartesian axis-unaligned orthogonal grid. In at least one example, the mesh can include an adaptive mesh refined (AMR) grid. In at least one example of the method 300, computing an adaptive solution comprises adjusting a solution function of the element in a way that preserves higher moments including a streaming term streaming out of the element. In at least one example of the method 300, the spatial basis functions can include discontinuous functions, for example polynomial or non-polynomial discontinuous functions.

Any of the steps, features, elements, or methods shown and described with reference to the method 300 FIG. 3 can be included alone or in any combination with any of the other examples of methods shown and described with reference to other figures. Likewise, any of the steps, features, elements, or methods shown and described with reference to other figures can be included alone or in any combination with the example of the method 300 shown in FIG. 3.

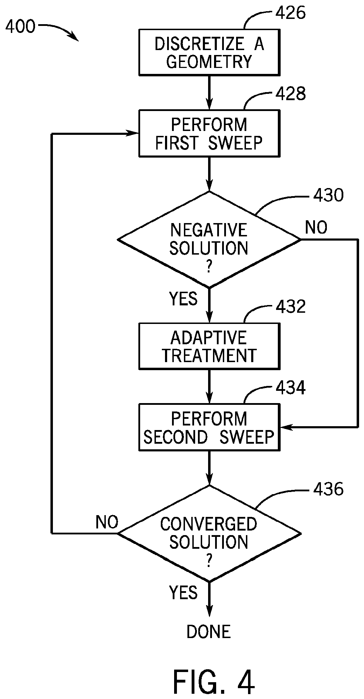

FIG. 4 illustrates a high-level flowchart of another example of a finite element method 400, according to the present disclosure, which can describe or include any of the other methods shown and described with reference to other figures. In at least one example, at 426 of the method 400, a geometry can be discretized. Next, at 428, a first sweep can be performed. At 430, during the first sweep, it can be determined whether any element of the discretized geometry yields a negative solution value. If so, at 432, the element can be treated adaptively as described herein. After the element is treated adaptively at 432, or if the element does not yield a negative solution value at 430, a second sweep can be performed at 434.

The second sweep can be performed according to the second sweeps described herein with reference to other figures and methods. Next, at 436 of the method 400, it can be determined whether a solution has converged. If so, the method is done. If not, the first sweep at 428 can be performed. In this way, the first and second sweeps of the method 400 can be iteratively performed until converging on the solution.

Any of the steps, features, elements, or methods shown and described with reference to the method 400 of FIG. 4 can be included alone or in any combination with any of the other examples of methods shown and described with reference to other figures. Likewise, any of the steps, features, elements, or methods shown and described with reference to other figures can be included alone or in any combination with the example of the method 400 shown in FIG. 4.

According to alternative examples, a varied form of the above-described adaptivity can be referred to as "Tetwise LDAS" (LDAST). The LDAST method is modified to use a mask array with one value per element, as opposed to a mask array with D values per element, as noted above. Accordingly, if any negativities are encountered along any discrete ordinate d in an element, adaptivity is applied along all *D* of the discrete ordinates in subsequent sweeps, instead of only along d.

Such an LDAST method may result in less accurate solutions than LDAS but has lower memory requirements (because of the size of M), and can be accelerated using Diffusion-Synthetic Acceleration (DSA) methods, such as the Simplified Wareing-Larsen-Adams DSA, as described in Discontinuous Finite Element Sn Methods On 3-D Unstructured Grids by T. A. Wareing, J. M. McGhee, J. E. Morel and S. D. Pautz (Nuclear Science and Engineering, 138(3): pp. 256-268, 2001; DOI: 10.13182/NSE138-256; URL: https://doi.org/10.13182/NSE138-256), which reference is incorporated by reference herein, for all that it contains.

Another alternative to examples of methods described herein can include adaptive treatment instead being implemented as the spatial lumping (*i.e.,* in-element averaging) of the scattering source term, followed by a repeat of the sweep without updating the source terms, rather than through the spatial lumping of the scattering source.

Another alternative example can include the finite element methods described herein applied not to a steady state fixed source problem, but to an eigenvalue problem being solved through successive source (*i.e.*, "outer" in nuclear reactor physics jargon) iterations.

Another alternative example can include the methods described herein with the energy domain discretized using other energy discretization methods (see, *e.g.*, Chapter 1 of Resonance Treatment Using the Discrete Generalized Multigroup Method by N. A. Gibson, S. M. thesis, Massachusetts Institute of Technology, Department of Nuclear Science and Engineering, 2013; DOI: 1721.1/80662; URL: http://hdl.handle.net/1721.1/80662, which reference is incorporated by reference herein, for all that it contains, for a summary of other energy discretization methods that exist), rather than into energy groups.

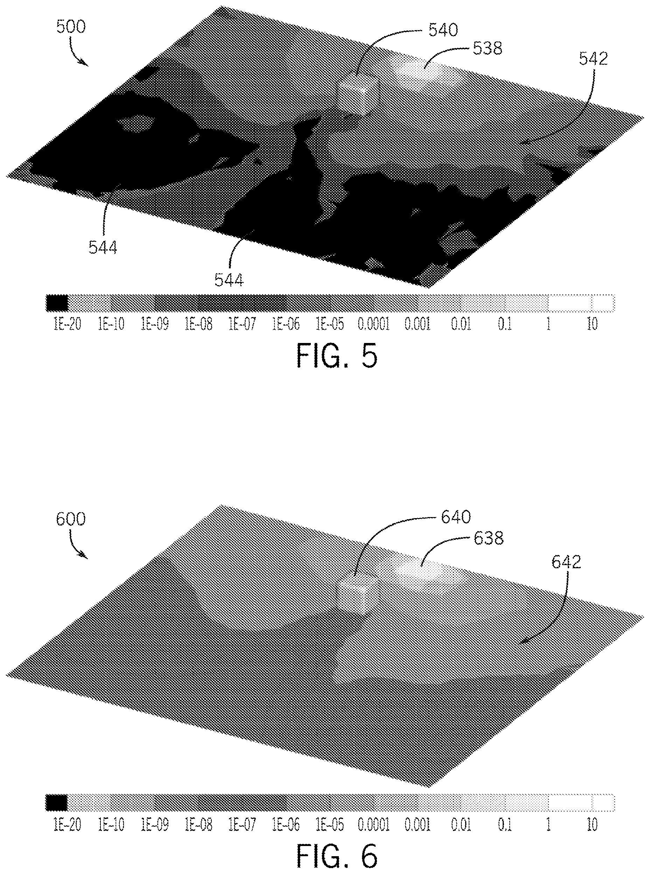

FIG. 5 illustrates a photon flux solution field 500 from a point source 538 shielded by a concrete shield 540, solved using with a conventional LDFEM spatial discretization. The black regions 544 on the plot 542 indicate the (nonphysical) negative solution, originating in a shadow of the shield 540 shadow and spreading outward via scattering.

FIG. 6 illustrates the same problem solved with an LDAS discretization described herein. No negativities are present in the solution, and contours of the solution field 642 are much smoother compared to those shown in FIG. 5. The smooth contours of FIG. 6 are a physically reasonable result.

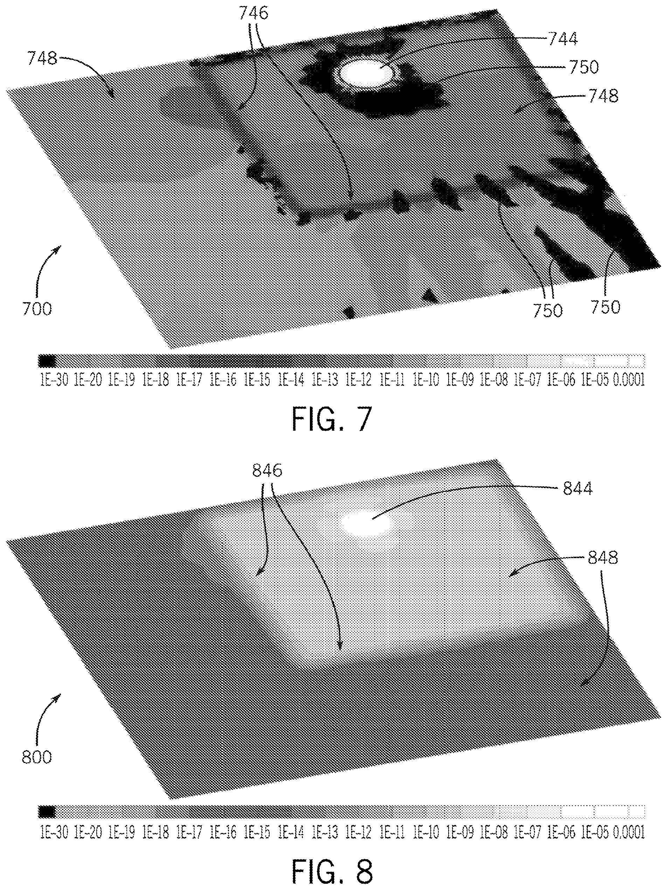

FIG. 7 illustrates a photon flux solution field 700 from a volume source 744 in a finned cask in a room with concrete walls 746, solved with a conventional LDFEM spatial discretization. The black regions 750 on the plot 748 indicate the (nonphysical) negative solution, originating due to the significant solution drop-off in the concrete walls 746.

FIG. 8 illustrates a photon flux solution field 800 of the same problem as shown in FIG. 7, including a volume source 844 in a finned cask in a room with concrete walls 846 but solved with the LDAS discretization methods described herein. No negativities are present in the solution, and again, the contours of the solution field 848 are much smoother, which is also a physically reasonable result.

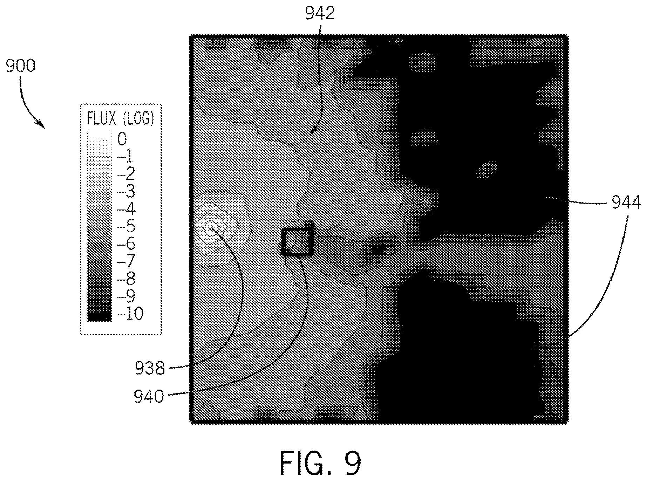

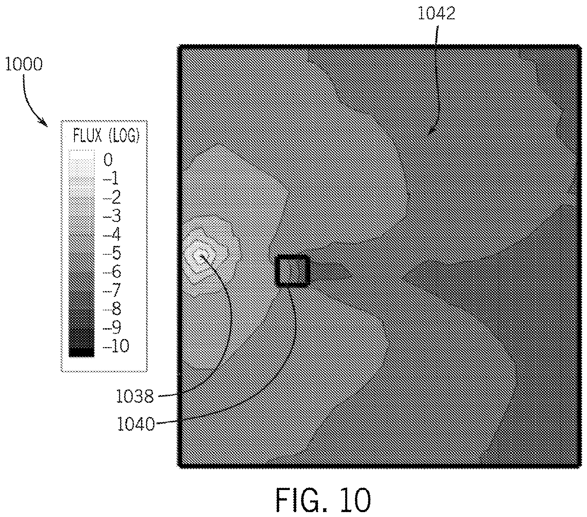

Figures 9 and 10 compare the performance between LD and LDAS in a low scattering problem, where angular quadrature (S_{N} order) induced "ray-effects" can create non-physical solution oscillations. The model 900 includes a localized ⁶⁰Co volume source 938 in void with a rectangular iron shield 940 shadowing part of the model 900. A Triangular Chebyshev-Legendre quadrature set is used with an *S_{N}* order of 12, yielding 268 angles on the unit sphere. As shown in Figure 9, ray effects are visible in the LD solution 942 which, with increasing radius from the source, eventually cause negative fluxes 944 to occur (represented in black).

The LDAS model 1000 and solution 1042 to the same problem is shown in FIG. 10, including a localized ⁶⁰Co volume source 938 in void with a rectangular iron shield 940 shadowing part of the model 900. Also, a Triangular Chebyshev-Legendre quadrature set is used with an *S_{N}* order of 12, yielding 268 angles on the unit sphere. As shown, the LDAS model 1000 of FIG. 10 is generally free from ray effects and the solution remains positive and smooth throughout.

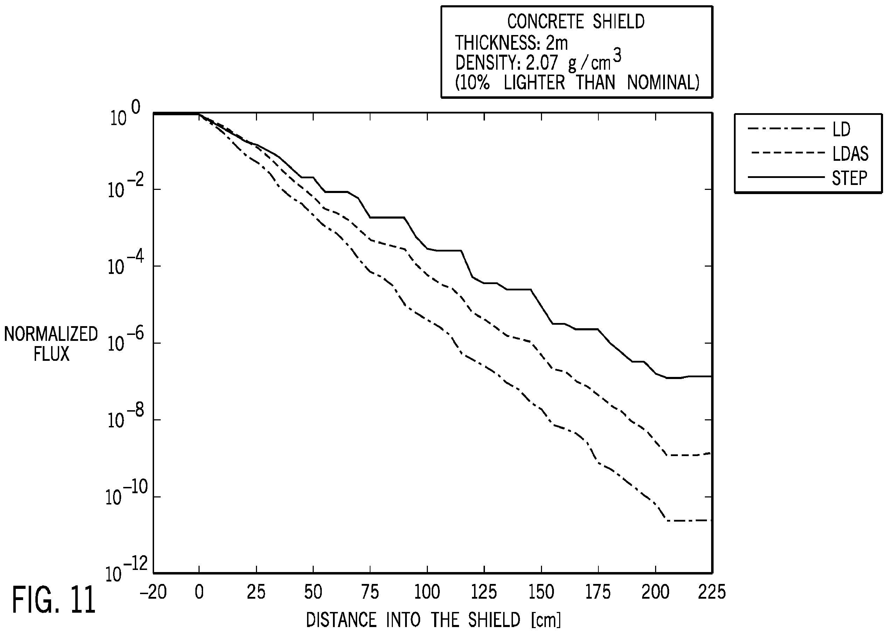

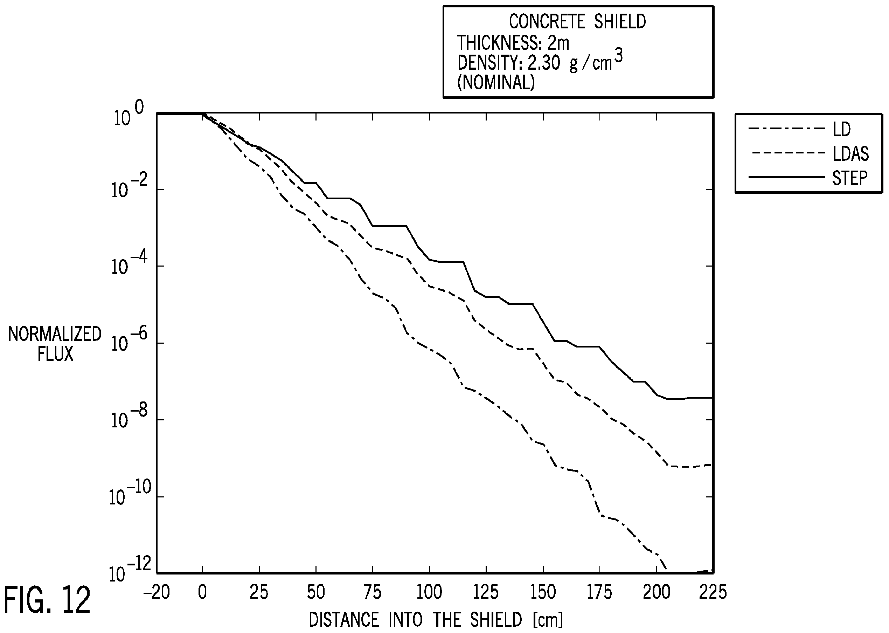

Figures 11-13 illustrate plots comparing the performance of LDAS versus LD and step spatial discretization for a ⁶⁰Co photon source with a 200cm thick concrete shield. Total photon flux is plotted at points spaced at 5 cm increment through the shield. The concrete densities are 2.07, 2.30, and 2.76 g/cc for Figures 1, 2, and 3, respectively. The same computational mesh was used in all cases, which had a 20 cm tetrahedral edge length in the high gradient direction.

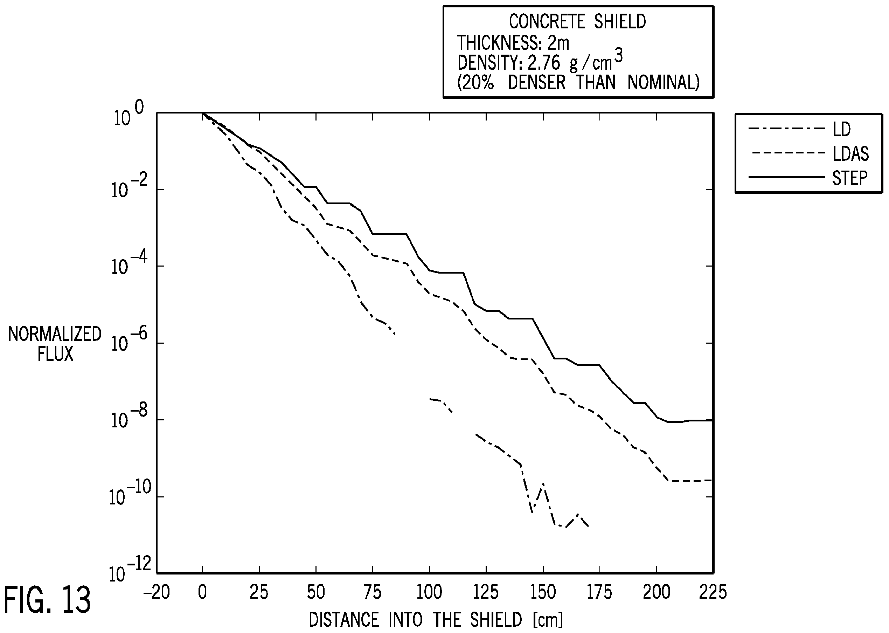

If the mesh size is small enough to resolve the solution, LD provides the most accurate solution. This is evident in the 2.07 g/cc case (Figure 1), where the slope of the LD solution is relatively smooth. However, when the density is increased to 2.76 g/cc (Figure 13), LD produces negative fluxes.

As is visible in all three plots of FIGS. 11, 12, and 13, step discretization predicts the most gradual drop through the shield, regardless of density. Additionally, as the step solution is uniform within each element, a stair stepped pattern is evident, where multiple points have the same value as they are located within the same element. In all three cases, LDAS provides a relatively smooth solution, with no negative fluxes, with better accuracy than step differencing.

While various aspects and embodiments have been disclosed herein, other aspects and embodiments are contemplated. The various aspects and embodiments disclosed herein are for purposes of illustration and are not intended to be limiting.

Terms of degree *(e.g.,* "about," "substantially," "generally," etc.) indicate structurally or functionally insignificant variations. In an example, when the term of degree is included with a term indicating quantity, the term of degree is interpreted to mean ± 10%, ±5%, +2% or 0% of the term indicating quantity. In an example, when the term of degree is used to modify a shape, the term of degree indicates that the shape being modified by the term of degree has the appearance of the disclosed shape. For instance, the term of degree may be used to indicate that the shape can have rounded corners instead of sharp corners, curved edges instead of straight edges, one or more protrusions extending therefrom, is oblong, is the same as the disclosed shape, *etc.*

## Claims

1. A finite element method using a discretized geometric mesh, the finite element method comprising:
initializing all values of a Boolean array mask to false, with each value corresponding to an element of the discretized geometric mesh;
performing a sweep through the discretized geometric mesh to compute a solution function at each element of the discretized geometric mesh;
while performing the sweep, and for each element having a negative solution value computed at any part of the element during the sweep, or for each element corresponding to a true value of the Boolean array mask, computing an adaptive solution function for the element and updating the mesh Boolean array by setting a value of the mesh Boolean array corresponding to the element to true; and
updating a scattering source term to use the adaptive solution functions.

2. The finite element method of claim 1, wherein:
the sweep is performed iteratively until converging onto a solution; and
each subsequent sweep of the iteratively performed sweeps uses the updated scattering source term and the updated mesh Boolean array.

3. The finite element method of claim 2, wherein converging on the solution includes a norm of the absolute or relative difference between the solution values computed at any part of the element during a previous sweep and a current sweep previous to the previous sweep being less than a predetermined value.

4. The method of claim 1, further comprising discretizing a solution field in each element into spatial basis functions, wherein:
the spatial basis functions comprise discontinuous polynomial functions; and
computing the adaptive solution function comprises a re-discretization and re-computation of the solution using a polynomial function of a higher or lower order; or optionally
wherein computing the adaptive solution function comprises averaging the solution function across the element.

5. The finite element method of claim 1, wherein each element is a tetrahedral mesh element; or optionally
wherein discontinuous linear spatial basis functions are used to represent the solution in each element of the discretized geometric mesh.

6. The finite element method of claim 1, wherein the discretized geometric mesh comprises pentahedral or hexahedral elements.

7. A finite element method for solving a steady state fixed source multigroup particle transport problem, the method comprising:
discretizing a problem geometry into a contiguous mesh of element-discrete ordinate pairs;
for each group of the multigroup:
initializing a Boolean array to all false values, with each value corresponding to an element-discrete ordinate pair;
performing a sweep through the geometry along each mesh-discrete ordinate pair, the sweep comprising:
updating the Boolean array by setting each value of the Boolean array corresponding to element-discrete ordinate pairs having a partially or fully negative solution to true; and
adaptively re-computing a non-negative solution function for each element-discrete ordinate pair having a partially or fully negative solution or for each element-discrete ordinate pair
corresponding to a true value of the Boolean array; and
iteratively performing the sweep using the updated Boolean array and updated combined external-plus-scattering source terms until a solution converges.

8. The method of claim 7, wherein adaptively computing a nonnegative solution function comprises averaging the solution function computed in a previous iteration of the iterative sweeps over the element-discrete ordinate pair; or optionally
wherein second or higher-order discontinuous polynomial basis functions are used to represent the solution in each element-discrete ordinate pair of the contiguous mesh.

9. The finite element method of claim 7, wherein exponential discontinuous basis functions are used to represent the solution in each element-discrete ordinate pair of the contiguous mesh; or optionally
wherein the contiguous mesh of elements comprises an unstructured mesh including elements having curved faces.

10. An electronic device, comprising:
a processor;
a memory unit in electronic communication with the processor and comprising non-transitory computer-readable electronic instructions that, when performed by the processor, cause the processor to solve a steady state fixed source multigroup particle transport problem by:
discretizing a problem geometry into a contiguous mesh of elements and discrete ordinates, with a solution in each element discretized into spatial basis functions;
performing a sweep through the geometry along each discrete ordinate and update a source term, performing the sweep comprising:
initializing all values of a mesh-sized Boolean array mask to false; and
during the performance of the sweep, if the solution in an element satisfies a predetermined condition:
set a Boolean array mask value corresponding to the element to true; and
adaptively treat the element by computing an adaptive solution value and setting the solution of the
element to the adaptive solution value; and
iteratively performing the sweep with subsequent sweeps including re-computing the source term to use the new solution values and adaptively treating all elements for which a corresponding Boolean array mask value is true.

11. An electronic device of claim 10, wherein the predetermined condition comprises a negative solution value in any part of the element or a true value of the Boolean array mask corresponding to the element.

12. An electronic device of claim 11, wherein the adaptive treatment is only applied to a group of elements along a discrete ordinate if the solution in a preset fraction of the elements in the group fails to meet the predetermined condition, the group of elements including:
a group of at least two adjacent elements; or
a predetermined group of elements.

13. An electronic device of claim 10, wherein the predetermined condition as applied to the solution of the mesh element along one of the discrete ordinates comprises:
a negative average solution value of an in-element solution function;
a negative solution value of more than a pre-specified fraction of a volume of the element; or
a gradient of an in-element solution of the element being steeper than a pre-specified maximum.

14. An electronic device of claim 10, wherein the contiguous mesh comprises:
tetrahedral elements;
a Cartesian axis-aligned orthogonal grid;
a Cartesian axis-unaligned orthogonal grid; or
an adaptive mesh refined grid.

15. An electronic device of claim 10, wherein computing an adaptive solution comprises adjusting a solution function of the element in a way that preserves higher moments including a streaming term streaming out of the element; or optionally
wherein the spatial basis functions comprise discontinuous functions including polynomial or non-polynomial discontinuous functions.
